# EUROPÄISCHE PATENTSCHRIFT

(11) **EP 3 497 541 B1**
(45) Veröffentlichungstag und Bekanntmachung des Hinweises auf die Patenterteilung: **30.12.2020**
(21) Anmeldenummer: 17739242.0
(22) Anmeldetag: 10.07.2017
(51) Int. Cl.: G06F 3/01, G06F 3/041

(54) **BEDIENEINHEIT FÜR EIN GERÄT, INSBESONDERE FÜR EINE FAHRZEUGKOMPONENTE**
OPERATING UNIT FOR A DEVICE, IN PARTICULAR FOR A VEHICLE COMPONENT
UNITÉ DE COMMANDE D'UN APPAREIL, EN PARTICULIER D'UN COMPOSANT DE VÉHICULE

(30) Priorität: 09.08.2016 DE 102016114697
(43) Veröffentlichungstag der Anmeldung: 19.06.2019
(73) Patentinhaber: Behr-Hella Thermocontrol GmbH, 70469 Stuttgart (DE)
(72) Erfinder: SCHWAB, Tobias, 59557 Lippstadt (DE); PANKRATZ, Harri, 59557 Lippstadt (DE)
(74) Vertreter: dompatent von Kreisler Selting Werner - Partnerschaft von Patent- und Rechtsanwälten mbB
(86) Internationale Anmeldenummer: PCT/EP2017/067229
(87) Internationale Veröffentlichungsnummer: WO 2018/028906

(56) Entgegenhaltungen:
- US-A1- 2011 276 878

## Beschreibung

Die Erfindung betrifft eine Bedieneinheit für ein Gerät, bei dem es sich insbesondere um eine Fahrzeugkomponente handelt. Insbesondere betrifft die Erfindung Bedieneinheiten mit aktivem haptischem Feedback mit Kräftekompensation, so dass in Folge des aktiven haptischen Feedback auftretende Schwingungen der Bedieneinheit ausgeglichen bzw. zumindest gedämpft werden.

Display-Baugruppen in Kraftfahrzeugen werden oftmals mit einem aktiven haptischen Feedback ausgerüstet. Dabei soll das Auslösen des Feedbacks auf einem mit nicht zu vernachlässigender Masse behafteten Bedienfeld keine unzulässige dynamische Kraftübertragung auf das Fahrzeug erzeugen, da diese je nach Einbausituation zu parasitären Geräuschen bzw. Vibrationen im Fahrzeug führen kann.

Desweiteren soll das haptische Feedback weitgehend unabhängig von der Elastizität der Befestigung im Fahrzeug sein.

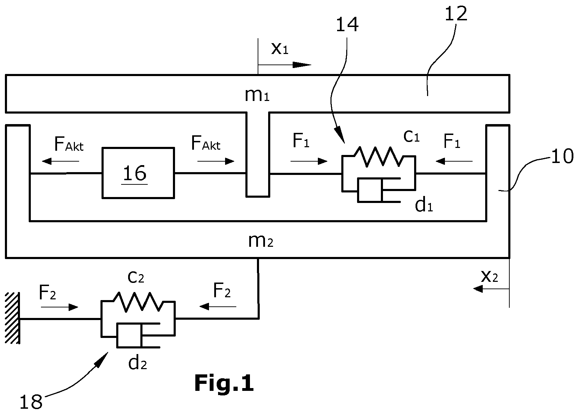

Ein mit einem aktiven haptischen Feedback ausgestattetes Gerät besteht im Wesentlichen aus einem Bedienfeld (z.B. Display), das über ein Federsystem am Gerätegehäuse elastisch befestigt ist, und einem Aktuator zur Auslenkung des Bedienfeldes. In Fig. 1 sind die wirkenden Kräfte in einem solchen Geräteaufbau dargestellt.

Zur Erzeugung des haptischen Feedbacks wird das Display mit einem bestimmten Wegverlauf x₁(t) aus seiner Ruhelage ausgelenkt. Die Displaybeschleunigung a₁(t) kann hierbei Werte von mehr als 30 m/s² annehmen, was bei einer bewegten Displaymasse m₁ von über 0,5 kg und einer in der Regel kleinen Gehäusemasse m₂ zu einer nicht zu vernachlässigenden dynamischen Kraft F₂(t) auf die Gerätebefestigung im Fahrzeug führt.

Bei einer steifen Gerätehalterung bzw. -befestigung (steifes Federsystem c₂, d₂) kann diese zeitlich schnell veränderliche Kraft unzulässige Geräusche bzw. Vibrationen im Fahrzeug verursachen.

Bei einer weichen Befestigung (weiches Federsystem c₂, d₂) dagegen erweist sich das Einhalten von Einbautoleranzen des Geräts im Fahrzeug als schwierig. Fernerhin ist die Abstimmung des erforderlichen Aktuatorkraftverlaufs F_{Akt}(t) durch das Vorhandensein eines weiteren Freiheitsgrades, nämlich der Gehäusebewegung x₂(t) und somit auch zusätzlicher Eigenfrequenzen im System, unter Umständen nicht möglich.

Aus DE-B-11 2011 101 553, US-A-2011/0276878 und US-A-2013/0127767 sind Bedieneinheiten gemäß dem Oberbegriff des Anspruchs 1 bekannt.

Aufgabe der Erfindung ist es, ein hinsichtlich der Entstehung von parasitären Geräuschen bzw. Vibrationen verbessertes Konzept für eine Bedieneinheit mit aktivem haptischem Feedback zu schaffen.

Zur Lösung dieser Aufgabe wird mit der Erfindung eine Bedieneinheit für ein Gerät, z. B. für eine Fahrzeugkomponente, insbesondere Mensch-Maschine-Interface (MMI bzw. HMI) vorgeschlagen, wobei die Bedieneinheit versehen ist mit
- einem Gehäuse, das ein Bedienfeld aufweist sowie zur Befestigung in einer Vorrichtung, insbesondere einer Fahrzeug-Instrumententafel oder Fahrzeug-Mittelkonsole vorgesehen ist,
- wobei das Bedienfeld elastisch an dem Gehäuse gelagert ist,
- einem Aktuator zur bei Erkennung einer Bedienung des Bedienfelds erfolgenden mechanischen Anregung des Bedienfelds und
- einem Ausgleichsgewicht,
- wobei das Ausgleichsgewicht bei Erkennung einer Bedienung des Bedienfelds von dem oder von einem Aktuator mechanisch anregbar ist und elastisch im und/oder am Gehäuse und/oder elastisch am Bedienfeld gelagert ist,
- wobei das Ausgleichsgewicht zum Ausgleich der bei mechanischer Anregung des Bedienfelds auf das Gehäuse wirkenden Kräfte (d. h. zum im Wesentlichen Ausgleichen einer Bewegung des Gehäuses bei Aktivierung des das Bedienfeld mechanisch anregenden Aktuators) bewegbar ist,
- wobei das Bedienfeld als Vorderseite einer Anzeigeeinheit ausgebildet ist, die elastisch an dem Gehäuse gelagert ist, und
- wobei das Ausgleichsgewicht als eine Hinterleuchtungseinheit zum Hinterleuchten der Anzeigeeinheit ausgebildet ist.

Wesensmerkmal der Erfindung ist die Verwendung eines hinterleuchteten Displays, wobei die Besonderheit darin besteht, dass die Hinterleuchtungseinheit, die die Lichtquellen und im Regelfall, aber nicht zwangsläufig, auch einen Diffusor zur vergleichmäßigenden Streuung des Hinterleuchtungslichts aufweist, von der eigentlichen Anzeigeeinheit getrennt ist, so dass beide unabhängig voneinander bewegbar sind. Das kann nun ausgenutzt werden, um durch vektoriell entgegengesetzte Anregungsbewegungen von Anzeigeeinheit und Hinterleuchtungseinheit für einen Vibrationsausgleich zu sorgen. Sofern die Hinterleuchtungseinheit keine Diffusoreigenschaften aufweist, befindet sich ein Diffusor zweckmäßigerweise insbesondere feststehend zwischen der Hinterleuchtungseinheit und der Anzeigeeinheit, z.B. an der Rückseite der Anzeigeeinheit.

Insbesondere von Vorteil ist es, wenn das Ausgleichsgewicht um im Wesentlichen 180° phasenverschoben zur Anregungsbewegung des Bedienfelds bewegbar ist, wobei der Bewegungshub des Ausgleichsgewichts unter Berücksichtigung zumindest der Relation der Masse des Bedienfelds zur Masse des Ausgleichsgewichts gewählt ist.

Bei der Erfindung ist also vorgesehen, dass die Hinterleuchtungseinheit vektoriell entgegengesetzt zur Anzeigeeinheit anregbar ist. Es kann ferner von Vorteil sein, wenn die Bewegungshübe von Anzeigeeinheit und Hinterleuchtungseinheit bei Anregung durch den oder die Aktuatoren ausgelegt sind in Abhängigkeit von der Relation der jeweiligen Massen von Anzeigeeinheit und Hinterleuchtungseinheit und/oder der Relation der Lage der Massenschwerpunkte von Anzeigeeinheit und Hinterleuchtungseinheit und/oder den Feder-Dämpfungselementen der jeweiligen elastischen Lagerungen von Anzeigeeinheit und Hinterleuchtungseinheit am Gehäuse und/oder der Größe der vektoriell entgegengesetzt zueinander gerichteten Bewegungshubkomponenten bzw. Bewegungshüben von Anzeigeeinheit und Hinterleuchtungseinheit.

In weiterer vorteilhafter Ausgestaltung der Erfindung kann vorgesehen sein, dass ein gemeinsamer Aktuator zur Bewegung sowohl der Anzeigeeinheit als auch der Hinterleuchtungseinheit vorgesehen ist, wobei der Aktuator ein längenveränderbares Stellglied mit zwei voneinander abgewandten Enden aufweist, deren Abstand durch gegensinnige Bewegung veränderbar ist und von denen das eine Ende mit der Anzeigeeinheit und das andere Ende mit der Hinterleuchtungseinheit zwecks mechanischer Anregung von Anzeigeeinheit und Hinterleuchtungseinheit in Wirkverbindung steht.

Erfindungsgemäß kann vorgesehen sein, dass der oder die Aktuatoren elektromechanisch oder piezoelektrisch arbeitet/arbeiten.

Die Erfindung wird nachfolgend anhand mehrerer Ausführungsbeispiele sowie unter Bezugnahme auf die Zeichnung näher erläutert. Im Einzelnen zeigen dabei:
- Fig. 1: schematisch die bei einer Bedieneinheit mit aktivem haptischen Feedback auftretenden Kräfte,
- Fig. 2: eine schematische Darstellung der auftretenden Kräfte bei erfindungsgemäßer Verwendung eines Gegengewichts als Ausgleichsmasse,
- Fig. 3: schematisch eine Konstruktion eines gegenkraftfreien haptischen Feedback bei einer Bedieneinheit,
- Fig. 4: eine schematische Darstellung eines mechanischen Aufbaus zur Übertragung eines Impulses auf eine Bedieneroberfläche ohne resultierende Gesamtkräfte bzw. Gesamtimpulse auf die mechanische Halterung,
- Fig. 5: eine schematische Darstellung des Aufbaus nach Fig. 4 jedoch mit piezoelektrisch arbeitendem Aktuator und
- Fig. 6: eine Erweiterung des Konzepts des Aufbaus nach Fig. 4 um eine Vorrichtung zur Bedienkrafterkennung.

Zunächst soll anhand der Fign. 1 bis 3 ganz allgemein auf das Konzept des Massenausgleichs bei einer Bedieneinheit mit Force-Feedback eingegangen werden.

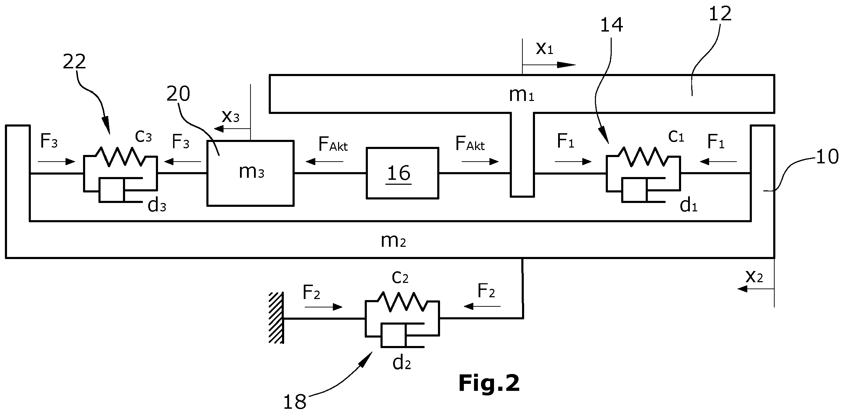

Erfindungsgemäß wird die Verwendung einer elastisch gelagerten (siehe Feder-Masse-System 22) beweglichen Gegenmasse 20 zwischen dem Aktuator 16 und dem Gehäuse 10 zum Ausgleich der auf das Gehäuse 10 wirkenden Kräfte vorgeschlagen (Fign. 1 und 2).

Bei entsprechender Auslegung des zusätzlichen Feder-Masse-Systems 22 bzw. c₃, d₃, m₃ kann die auf das Fahrzeug wirkende, resultierende Kraft Fz(t) eliminiert werden (die durch Gravitation entstehenden statischen Kräfte spielen bei der Entstehung von Geräuschen bzw. Vibrationen keine Rolle).

Für eine beliebig vorgegebene Displayauslenkung x₁(t) kann die Auslenkung x₂(t)/Bewegung des Gerätegehäuses und somit auch die Kraft F₂(t) auf die Gerätebefestigung unter folgenden Bedingungen eliminiert werden: ${c}_{3} = {c}_{1} \frac{{m}_{3}}{{m}_{1}} , {d}_{3} = {d}_{1} \frac{{m}_{3}}{{m}_{1}}$

Daraus ergibt sich die Auslenkung der Gegenmasse 20: ${x}_{3} \left(t\right) = {x}_{1} \left(t\right) \frac{{m}_{1}}{{m}_{3}}$

Unter diesen Bedingungen hat auch die Elastizität der Gerätebefestigung 18 keinen Einfluss auf das haptische Feedback. Die Gegenmasse 20 bzw. m₃ ist in der Regel durch die Bauraumvorgaben eingeschränkt und ist kleiner als die Displaymasse m₁. Idealerweise kann sie als ein Teil des Aktuators 16 ausgeführt werden.

Die vorliegende Erfindung ermöglicht es
- ein haptisches Feedback auf massebehafteten Oberflächen ohne dynamische Krafteinwirkung auf die Umgebung zu erzeugen.
- ein haptisches Feedback in einem Bediengerät zu erzeugen, das unabhängig von der Elastizität der Gerätebefestigung ist.

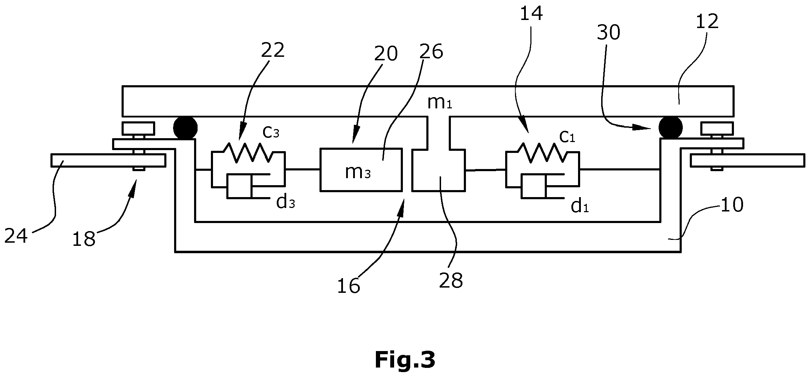

In Fig. 3 ist eine Vorrichtung mit einem gegenkraftfreien haptischen Feedback skizziert.

Im dargestellten Beispiel ist der Aktuator 20 als Zugmagnet ausgebildet und weist ein am Gehäuse 10 elastisch gelagertes Statorblechpaket mit der Aktuatorspule (Stator 26) und einem am Display 10 fest angebundenen Ankerblechpaket (Anker 28) auf. Der Stator 26 bildet die bewegliche Gegenmasse 20. Bei der Einstellung des Luftspalts im Zugmagnet muss die maximale Auslenkung des Displays 10 und des Ausgleichsgewichts 20 zueinander berücksichtigt werden. Der Stator 26 ist elastisch (Feder-Masse-System 22) am Gehäuse 10 gelagert, kann aber auch stattdessen am Bedienfeld 12 elastisch angebunden sein.

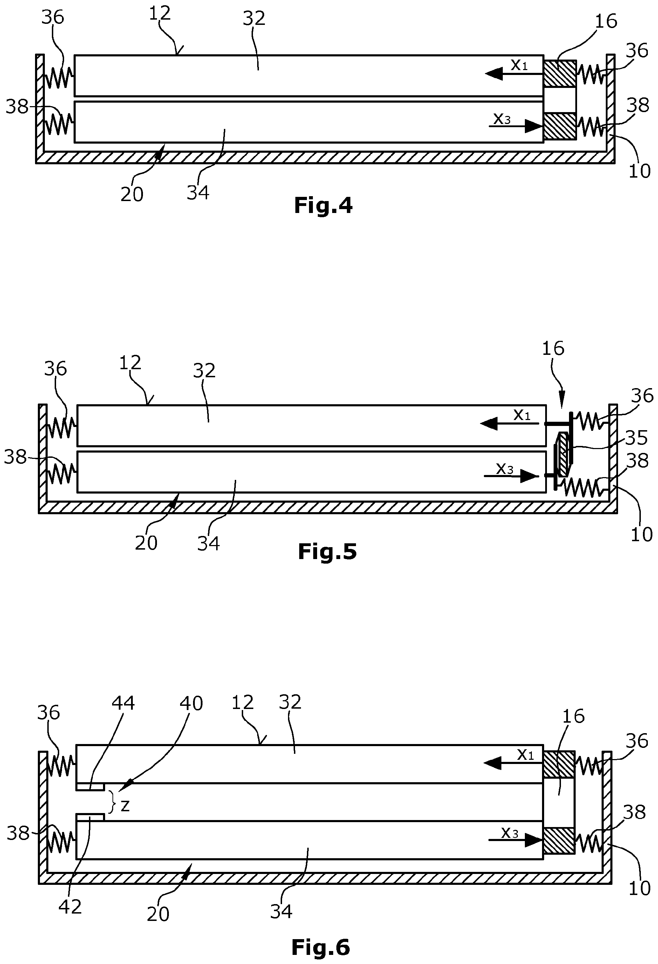

Anhand der Fign. 4 bis 6 werden nachfolgend mögliche mechanische Aufbauten einer Bedieneinheit mit einem Anzeige- und Bedienelement, welches hinterleuchtet ist, näher erläutert. Soweit in diesen Figuren die gleichen Bezugszeichen wie in den Fign. 1 bis 3 verwendet werden, bezeichnen sie baugleiche oder funktionsgleiche Elemente.

Gemäß Fig. 4 erzeugt der Aktuator 16 nach seiner Aktivierung Kräfte, die zur Beschleunigung und Bewegung von zwei an ihm befestigten, voneinander getrennten Bauteilen, nämlich einer (z.B. LCD-)Anzeigeeinheit 32 und einer Hinterleuchtungseinheit 34 für die Anzeigeeinheit 32 führen. Die Bewegungen von Anzeigeeinheit 32 und Hinterleuchtungseinheit 34 sind durch x₁ und x₃ gekennzeichnet. Der Aktuator 16 ist im Wesentlichen dadurch gekennzeichnet, dass er die Anzeigeeinheit 32 und die Hinterleuchtungseinheit 34 um 180° phasenverschoben gegeneinander auslenkt. Hierfür kann der Aktuator 16 z.B. als Elektromagnet, Piezoelement, etc. ausgelegt sein. Die in Fig. 4 gezeigte Anordnung des Aktuators 16 ist eine mögliche Ausführungsart. Im Allgemeinen ist die Integration des Aktuators 16 lediglich durch das resultierende Auslösen der Bewegungen x₁ und x₃ von Anzeigeeinheit 32 und Hinterleuchtungseinheit 34 bestimmt, was z.B. durch die Anordnung des Aktuators 16 unterhalb der Hinterleuchtungseinheit 34 erfolgen kann.

In Fig. 5 ist ein Ausführungsbeispiel mit Piezo-Aktuator 16 darstellt. Der Aktuator 16 weist ein piezoelektrisches Material 35 auf, welches sich beim Anlegen einer Spannung mechanisch verformt. Die Anzeigeeinheit 32 und die Hinterleuchtungseinheit 34 sind mechanisch an unterschiedlichen Seiten des piezoelektrischen Materials 35 des Aktuators 16 angebunden.

Die Anzeigeeinheit 32 weist eine vom Benutzer berührbare Oberfläche (Bedienfeld 12) auf. Die Hinterleuchtungseinheit 34 ist nicht vom Benutzer berührbar und darüber hinaus von der berührbaren Oberfläche der Anzeigeeinheit 32 sowie der Anzeigeeinheit 32 selbst entkoppelt. Der Nutzer spürt die Rückmelde-Bewegung der Anzeigeeinheit 32 nach Anregung durch den Aktuator 16 mittels Übertragung von Kraft, z.B. Impuls, auf das jeweilige Eingabemittel, d.h. beispielsweise den Finger, so dass eine haptische Rückmeldung nach valider Interaktion mit der Bedieneinheit erreicht wird.

Eine gesamtimpuls- und gesamtkraftfreie mechanische Halterung im Gehäuse 10 wird erreicht, wenn
- sich die Anzeigeeinheit 32 vektoriell entgegengesetzt zur Hinterleuchtungseinheit 34 bewegt, z.B. wenn sich die Anzeigeeinheit 32 in positiver X-Richtung und gleichzeitig die Hinterleuchtungseinheit 34 in negativer X-Richtung bewegt, und
- die Feder-Dämpfungselemente 36 und 38, mit denen die Anzeigeeinheit 32 sowie die Hinterleuchtungseinheit 34 jeweils elastisch an das Gehäuse 10 angebunden sind, so ausgelegt sind, dass sich die aufgenommenen lokalen Impulse von Anzeigeeinheit 32 und Hinterleuchtungseinheit 34 in Summe aufheben.

Dieser Ansatz setzt im Allgemeinen Folgendes nicht voraus, schließt es aber auch nicht aus:
- Massengleichheit von Anzeigeeinheit 32 und Hinterleuchtungseinheit 34,
- Weggleichheit (x₁,x₃, nach Betrag) von Anzeigeeinheit 32 und Hinterleuchtungseinheit 34 und
- Gleichheit der Feder-Dämpfungselemente 36,38.

Im Speziellen hat das Bedienelement folgenden Aufbau:
- Nutzeroberfläche, z.B. Coverglas mit gebondetem Touchsensor und LC-Zellen eines LC-Displays der LCD-Anzeigeeinheit 32, aufweisend zwei Linearpolarisatoren, TFT- & Farbfilterglas, LC und alle für dessen Funktion relevanten Komponenten und
- Hinterleuchtungseinheit 34 (Backlight) des LC-Displays mit optischen Diffusorschichten, LEDs und allen relevanten Komponenten.

Im Vergleich zum Stand der Technik von LC-Displays, in denen die Anzeigeeinheit 32 und die Hinterleuchtungseinheit 34 keine Relativbewegungen zueinander ausführen können, ist erfindungsgemäß eine freie Bewegung zwischen beiden Komponenten vorgesehen. Beide Komponenten erfüllen ihre volle Funktionalität, wie es von hinterleuchteten Displays bekannt ist. Weiterhin sollten die Relativbewegungen von Anzeigeeinheit 32 und Hinterleuchtungseinheit 34 so gering sein, dass keine negativen optischen Effekte, z.B. durch Lichtaustritt oder Abschottung von Licht, zu beobachten sind (Bewegungen jeweils kleiner als 1 mm). Der Eintrag von Staub und/oder Wasser ins Display wird durch eine elastische Einfassung (z.B. weiche Gummierung) verhindert. Die elastische Einfassung verhindert weiterhin den Austritt von Licht der Hinterleuchtungseinheit 34.

Im Vergleich zum Stand der Technik für haptische Rückmeldungen eines Geräts mit Anzeigeelement (Display), bei denen das gesamte Anzeigeelement inklusive Backlight bewegt wird, reduziert sich mit der Erfindung die zu bewegende Masse mit Anbindung zur Benutzeroberfläche auf das Gewicht der Hinterleuchtungseinheit 34 und der an dieser mechanisch angebundenen Bauteile. Weiterhin dient die Hinterleuchtungseinheit 34 als Ausgleichsgewicht 20 für die Anzeigeeinheit 32 und somit als entscheidendes Bauteil zur gesamtimpulsfreien Auslegung des Gesamtgeräts. Im Besonderen werden keine weiteren Gegengewichte zur Aufhebung des Gesamtpulses benötigt und somit das Systemgewicht insgesamt reduziert.

Durch die geringere Masse der mit der Nutzeroberfläche in Verbindung stehenden Komponenten wird entweder ein stärkeres haptisches Feedback für den Nutzer bei gleichem Aktuator 16 oder die Auslegung eines kleineren Aktuators 16 bei gleichem, spürbarem Feedback ermöglicht.

Zusammenfassend wird durch die hier beschriebene Erfindung ein haptisches Feedback auf der Nutzeroberfläche erreicht, und zwar ohne Impuls- und Kraftübertrag der Bedienfeld-Anzeigeeinheit 32 auf die Geräteumgebung, was durch Aufteilung des LC-Displays sowie der zusätzlichen Funktionsgebung der Hinterleuchtungseinheit 34 (Backlight) als Ausgleichsgewicht 20 zur Anzeigeeinheit 32 mit Nutzer-Bedienoberfläche realisiert ist.

Fig. 6 zeigt eine Erweiterung des Konzepts nach Fign. 4 und 5 um die Erkennung der Bedienkraft bei der Interaktion des Nutzers mit der Anzeigeeinheit 32.

Zur Erkennung der Bedienkraft wird eine z.B. kapazitiv, resistiv, induktiv oder optisch arbeitende Abstandssensorik 40 aus z.B. mehreren Paaren von optischen Sendern 42 und Empfängern 44 vorgesehen. Unter Einwirkung des Nutzers findet bei der manuellen Betätigung des Bedienfelds 12 der Anzeigeeinheit 32 eine Änderung des Relativabstands z zwischen der Anzeigeeinheit 32 und der Hinterleuchtungseinheit 34 statt, so dass eine oder mehrere Systemobservablen der Sender 42 und Empfänger 44 zur Detektion der Änderung genutzt werden können.

Die Integration der Abstandssensorik 40 für das genannte spezielle LC-Display erfolgt z.B. in den jeweiligen Einfassungen (Rahmen) der Anzeigeeinheit 32 und der Hinterleuchtungseinheit 34.

### BEZUGSZEICHENLISTE

- 10: Gehäuse
- 12: Bedienfeld
- 14: elastische Anbindung des Bedienfeldes 12 am Gehäuse
- 16: Aktuator
- 18: Anbindung des Gehäuses ans Fahrzeug
- 20: Ausgleichsgewicht
- 22: elastische Anbindung des Ausgleichsgewichts am Gehäuse und/oder am Bedienfeld 12
- 24: Fahrzeug bzw. Instrumententafel des Fahrzeugs
- 26: Stator des als Aktuator ausgeführten Zugmagnets
- 28: Anker des Zugmagnets
- 30: Bedienfeldführung für die Bewegung bei haptischer Rückmeldung
- 32: Anzeigeeinheit
- 34: Hinterleuchtungseinheit
- 35: piezoelektrisches Material
- 36: Feder-Dämpfungselement
- 38: Feder-Dämpfungselement
- 40: Abstandssensorik
- 42: Sender der Abstandssensorik
- 44: Empfänger der Abstandssensorik
- m₁: Masse des Bedienfelds
- x₁(t): Auslenkung des Bedienfelds
- F_{Akt}(t): Aktuatorkraftverlauf
- F₁(t): auf das Gehäuse wirkende Kraft des Bedienfelds bei Anregung desselben (F₁(t) = F_{Akt} - m₁ x a₁)
- c₁: Federkonstante der elastischen Anbindung des Bedienfelds am Gehäuse
- di: Dämpfung der elastischen Anbindung des Bedienfelds am Gehäuse
- m₂: Masse des Gehäuses
- x₂(t): Auslenkung des Gehäuses in Folge der durch das mechanisch angeregte Bedienfeld ausgeübten Kraft
- F₂(t): auf die Gehäusebefestigung wirkende Kraft
- m₃: Masse des Ausgleichsgewichts
- x₃(t): Auslenkung des Ausgleichsgewichts
- F₃: durch das Ausgleichsgewicht auf das Gehäuse wirkende Kraft
- c₃: Federkonstante der elastischen Anbindung des Ausgleichsgewichts am Gehäuse
- d₃: Dämpfung der elastischen Anbindung des Ausgleichsgewichts am Gehäuse
- z: Abstand zwischen Anzeigeeinheit und Hinterleuchtungseinheit

## Patentansprüche

1. Bedieneinheit für ein Gerät, z.B. für eine Fahrzeugkomponente, insbesondere Mensch-Maschine-Interface, mit
- einem Gehäuse (10), das ein Bedienfeld (12) aufweist sowie zur Befestigung in einer Vorrichtung, insbesondere einer Fahrzeug-Instrumententafel oder Fahrzeug-Mittelkonsole vorgesehen ist,
- wobei das Bedienfeld (12) elastisch an dem Gehäuse (10) gelagert ist,
- einem Aktuator (16) zur bei Erkennung einer Bedienung des Bedienfelds (12) erfolgenden mechanischen Anregung des Bedienfelds (12) und
- einem Ausgleichsgewicht (20),
- wobei das Ausgleichsgewicht (20) bei Erkennung einer Bedienung des Bedienfelds (12) von dem oder von einem Aktuator (16) mechanisch anregbar ist und elastisch im und/oder am Gehäuse (10) und/oder elastisch am Bedienfeld (12) gelagert ist,
- wobei das Ausgleichsgewicht (20) zum Ausgleich der bei mechanischer Anregung des Bedienfelds (12) auf das Gehäuse (10) wirkenden Kräfte bewegbar ist und
- wobei das Bedienfeld (12) als Vorderseite einer Anzeigeeinheit (32) ausgebildet ist, die elastisch an dem Gehäuse (10) gelagert ist,
**dadurch gekennzeichnet,**
- **dass** das Ausgleichsgewicht (20) als eine Hinterleuchtungseinheit (34) zum Hinterleuchten der Anzeigeeinheit (32) ausgebildet ist.

2. Bedieneinheit nach Anspruch 1, **dadurch gekennzeichnet, dass** die Bewegungshübe von Anzeigeeinheit (32) und Hinterleuchtungseinheit (34) bei Anregung durch den oder die Aktuatoren (16) ausgelegt/bestimmt sind in Abhängigkeit von der Relation der jeweiligen Massen von Anzeigeeinheit (32) und Hinterleuchtungseinheit (34) und/oder der Relation der Lage der Massenschwerpunkte von Anzeigeeinheit (32) und Hinterleuchtungseinheit (34) und/oder den Feder-Dämpfungselementen (36,38) der jeweiligen elastischen Lagerungen von Anzeigeeinheit (32) und Hinterleuchtungseinheit (34) am Gehäuse und/oder der Größe der vektoriell entgegengesetzt zueinander gerichteten Bewegungshubkomponenten bzw. Bewegungshüben von Anzeigeeinheit (32) und Hinterleuchtungseinheit (34).

3. Bedieneinheit nach Anspruch 1 oder 2, **dadurch gekennzeichnet, dass** ein gemeinsamer Aktuator (16) zur Bewegung sowohl der Anzeigeeinheit (32) als auch der Hinterleuchtungseinheit (34) vorgesehen ist, wobei der Aktuator (16) ein längenveränderbares Stellglied mit zwei voneinander abgewandten Enden aufweist, deren Abstand durch gegensinnige Bewegung veränderbar ist und von denen das eine Ende mit der Anzeigeeinheit (32) und das andere Ende mit der Hinterleuchtungseinheit (34) zwecks mechanischer Anregung von Anzeigeeinheit (32) und Hinterleuchtungseinheit (34) in Wirkverbindung steht.

4. Bedieneinheit nach einem der Ansprüche 1 bis 3, **dadurch gekennzeichnet, dass** der oder die Aktuatoren (16) elektromechanisch oder piezoelektrisch arbeitet/arbeiten.

## Claims

1. Operating unit for a device, e.g. for a vehicle component, in particular a man-machine interface, comprising
- a housing (10) which comprises an operating panel (12) and is provided for attachment in an apparatus, particularly a vehicle dashboard or vehicle center console,
- the operating panel (12) being elastically supported at the housing (10),
- an actuator (16) for mechanically exciting the operating panel (12) when operation of the operating panel (12) is detected, and
- a balance weight (20),
- the balance weight (20) being mechanically excitable by the or by an actuator (16) when operation of the operating panel (12) is detected and is elastically supported in and/or at the housing (10) and/or is elastically supported at the operating panel (12),
- the balance weight (20) being movable to compensate for the forces acting on the housing (10) when the operating panel (12) is mechanically excited, and
- the operating panel (12) being designed as a front side of a display unit (32) that is elastically supported at the housing (10),
**characterized in**
- **that** the balance weight (20) is designed as a backlight unit (34) for backlighting the display unit (32).

2. Operating unit of claim 1, **characterized in that** the movement strokes of the display unit (32) and the backlight unit (34), when excited by the actuator or the actuators (16), are configured/determined as a function of the relation between the respective masses of the display unit (32) and the backlight unit (34) and/or the relation between the position of the centers of mass of the display unit (32) and the backlight unit (34) and/or the spring damper elements (36, 38) of the respective elastic supports of the of the display unit (32) and the backlight unit (34) at the housing and/or the magnitude of the vectorially oppositely directed movement stroke components or movement strokes of the of the display unit (32) and the backlight unit (34).

3. Operating unit of claim 1 or 2, **characterized in that** a common actuator (16) is provided for moving both the display unit (32) and the backlight unit (34), the actuator (16) comprising a length-variable actuator element with two ends averted from each other, the distance between the ends being variable by movement in opposite directions and one end being operatively connected with the display unit (32) and the other end being operatively connected with the backlight unit (34) for mechanical excitation of the display unit (32) and the backlight unit (34).

4. Operating unit of one of claims 1 to 3, **characterized in that** the actuator or the actuators (16) operates/operate electromechanically or piezo-electrically.

## Revendications

1. Unité de commande pour un appareil, par exemple pour un composant de véhicule, en particulier une interface homme-machine, dotée
- d'un boîtier (10) comportant un champ de commande (12) et étant prévu pour être fixé dans un dispositif, en particulier un tableau de bord de véhicule ou une console centrale de véhicule,
- dans laquelle le champ de commande (12) est disposé élastiquement sur le boîtier (10),
- d'un actionneur (16) permettant une excitation mécanique subséquente du champ de commande (12) lorsqu'une commande du champ de commande (12) est reconnue et
- d'un contrepoids (20),
- dans laquelle le contrepoids (20) est mécaniquement excitable par le ou par un actionneur (16) lorsqu'une commande du champ de commande (12) est reconnue et est disposé élastiquement dans et/ou sur le boîtier (10) et/ou disposé élastiquement sur le champ de commande (12),
- dans laquelle le contrepoids (20) est mobile afin de compenser des forces s'exerçant sur le boîtier (10) lors d'une excitation mécanique du champ de commande (12) et
- dans laquelle le champ de commande (12) est réalisé comme face avant d'une unité d'affichage (32), laquelle est disposée élastiquement sur le boîtier (10),
**caractérisée en ce que**
- le contrepoids (20) est réalisé comme une unité de rétroéclairage (34) destinée au rétroéclairage de l'unité d'affichage (32).

2. Unité de commande selon la revendication 1, **caractérisée en ce que** les courses de l'unité d'affichage (32) et de l'unité de rétroéclairage (34) lors de l'excitation par le ou les actionneurs (16) sont configurées/déterminées en fonction de la relation des masses respectives de l'unité d'affichage (32) et de l'unité de rétroéclairage (34) et/ou de la relation des positions des centres de gravité de l'unité d'affichage (32) et de l'unité de rétroéclairage (34) et/ou des éléments amortisseurs à ressort (36, 38) des logements élastiques respectifs de l'unité d'affichage (32) et de l'unité de rétroéclairage (34) sur le boîtier et/ou de la grandeur des courses ou des composantes de course dirigées de manière vectoriellement inverse l'une par rapport à l'autre de l'unité d'affichage (32) et de l'unité de rétroéclairage (34).

3. Unité de commande selon la revendication 1 ou 2, **caractérisée en ce qu'**un même actionneur (16) est prévu pour mouvoir aussi bien l'unité d'affichage (32) que l'unité de rétroéclairage (34), dans laquelle l'actionneur (16) comporte un vérin variable en longueur avec deux extrémités se détournant l'une de l'autre, dont l'écart est variable par mouvement en sens opposé et desquelles l'une extrémité est reliée de manière opérante à l'unité d'affichage (32) et l'autre extrémité est reliée de manière opérante à l'unité de rétroéclairage (34) en vue de l'excitation mécanique de l'unité d'affichage (32) et de l'unité de rétroéclairage (34).

4. Unité de commande selon l'une des revendications 1 à 3, **caractérisée en ce que** le ou les actionneurs (16) fonctionne(nt) de manière électromécanique ou piézoélectrique.
